# EUROPEAN PATENT APPLICATION

(11) **EP 3 133 805 A1**
(43) Date of publication of application: **22.02.2017**
(21) Application number: 15780600.1
(22) Date of filing: 03.04.2015
(51) Int. Cl.: H04N 5/225

(54) **IMAGE SENSOR AND MONITORING SYSTEM**

(30) Priority: 13.04.2014 CN 201410149394
(71) Applicant: BYD Company Limited, Shenzhen 518118 (CN)
(72) Inventor: FENG, Wei, Shenzhen Guangdong 518118 (CN); CHEN, Zengqiang, Shenzhen Guangdong 518118 (CN); FU, Jingjun, Shenzhen Guangdong 518118 (CN)
(74) Representative: Haseltine Lake LLP
(86) International application number: PCT/CN2015/075873
(87) International publication number: WO 2015/158210

(57) **Abstract**

The present invention proposes an image sensor and a monitoring system, the image sensor including: a color filter arranged to allow a particular-wavelength infrared light to pass for light in infrared wavebands, and comprising a plurality of n-color filters, wherein each of the plurality of n-color filters corresponds to one color, the plurality of n-color filters are configured to divide visible light of incident light into n-color light, wherein n is a positive integer; and a light-sensitive chip located below the color filter, wherein the light-sensitive chip comprises a signal processing circuit and a plurality of light-sensitive units one-to-one corresponding to the plurality of n-color filters, the plurality of light-sensitive units are respectively arranged to sense intensity of light transmitting through the plurality of n-color filters and to generate electric signals corresponding to the light transmitting through the plurality of n-color filters, the signal processing circuit is configured to process the electric signals for imaging; wherein a gain ratio of the signal processing circuit to the electric signals is A1: A2: ...: An, and an intensity transmittance ratio of the plurality of n-color filters of the color filter to the particular-wavelength infrared light is 1: (A1/A2): ...: (A1/An). Through the image sensor of the present invention, the color of a shot image is the same as that observed by human eyes; and when visible light is weak while infrared light is strong, a clear black-and-white image can be shot, which has a wide application range and is convenient and reliable.

## Description

### Field

The present invention relates to the field of image imaging technologies, and particularly to an image sensor and a monitoring system.

### BACKGROUND

A sensitive spectral range of the human eyes is visible spectrums of 380 nm to 780 nm, while the human eyes cannot perceive spectrums in infrared wavebands. A sensing spectral range of a Complementary Metal-Oxide-Semiconductor Transistor (CMOS) image sensor is wider than that of the human eyes, and a silica-based material may be better sensitive to infrared rays of 940 nm. In certain applications (e.g., security and protection monitoring applications), to make the CMOS image sensor shoot a clearer image without changing an observation effect of the human eyes, it is common to use an infrared light lamp to compensate light so as to avoid causing alarm.

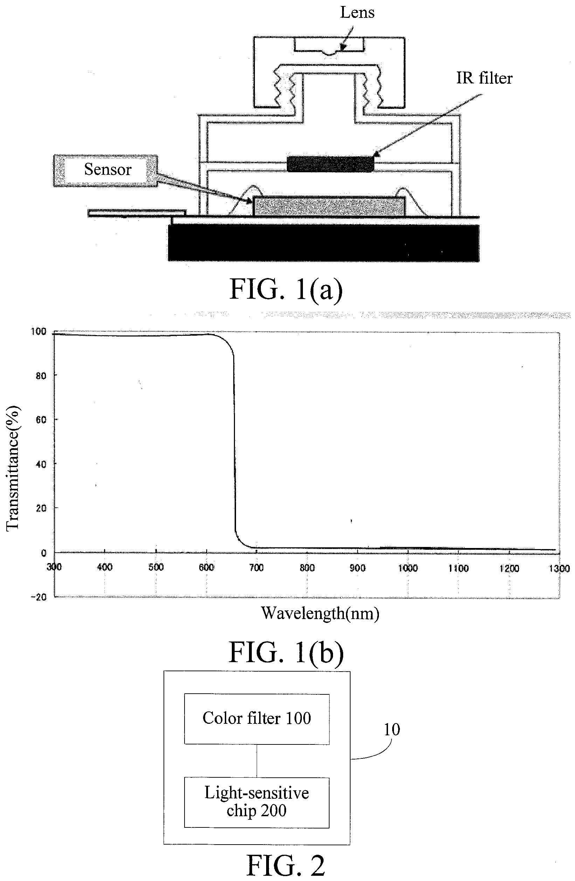

When visible light and infrared light co-exist in an environment (e.g., in the sun), black objects made of certain materials completely absorb visible spectrums but may partially reflect the infrared light; for the objects made of such materials, what the human eyes sees is black ones, while as the CMOS image sensor can sense visible light and infrared light at the same time, the color imaged is red purple instead of black. That is, the color of an image shot by the CMOS image sensor may not be the same as that of an image observed by the human eyes. In certain applications (e.g., security and protection monitoring applications), it is generally required as follows: when the human eyes can clearly observe (e.g., in daytime), the color of an image shot by machine equipment should be loyal to the human eyes; if the human eyes cannot clearly observe (e.g., in the evening), the machine equipment can provide a real color or a black-and-white image. To solve this problem, a practice in the related art is increasing an infrared cut-off filter (IR filter) on a sensitive channel of the CMOS image sensor before the CMOS image sensor senses light, as shown in FIG. 1(a), the filter only allows visible light to pass but filters infrared light, and spectral characteristics of the IR filter are as shown in FIG. 1(b).

The IR filter may be fixed, and may also be moveable. However, this will lead to the following problems: (1) if the IR filter is fixed, the IR filter enables the CMOS image sensor to only receive light in visible light wavebands, so as to obtain the image color the same as that observed by the human eyes, but light cannot be compensated in the evening through an infrared lamp, thus resulting in that the image shot by the CMOS image sensor is unclear; (2) if the IR filter is moveable, the light channel has the IR filter in daytime, which can filter infrared light, so as to obtain pictures in the same color as that observed by the human eyes, and when an infrared fill light lamp is used in the evening to compensate light, the filter is removed, the infrared light is allowed to pass, and a clear evening picture is obtained, and then the IR filter needs to use a mechanical motion structure to control and move the filter, the solution is at a high cost and complex in structure, and the mechanical structure has poor reliability and is easy to damage, which cannot reliably and stably work normally for a long time when used in high and low temperature environments for a long time.

### SUMMARY

The present invention is aimed at at least solving one of the above technical defects.

To this end, a first objective of the present invention is to propose one image sensor. According to the image sensor, when visible light and infrared light co-exist in an environment (e.g., in the sun), the color of a shot image is the same as that observed by the human eyes; in an environment where visible light is weak while infrared light is strong (e.g., when a fill light lamp is used to compensate light in the evening), a clear black-and-white image can be shot, which has a wide application range and is convenient and reliable.

A second objective of the present invention is to propose one monitoring system.

A third objective of the present invention is to propose another image sensor.

A fourth objective of the present invention is to propose another monitoring system.

To achieve the above objective, an image sensor according to an embodiment in a first aspect of the present invention includes: a color filter arranged to allow a particular-wavelength infrared light to pass for light in infrared wavebands, and comprising a plurality of n-color filters, wherein each of the plurality of n-color filters corresponds to one color, the plurality of n-color filters are configured to divide visible light of incident light into n-color light, wherein n is a positive integer; and a light-sensitive chip located below the color filter, wherein the light-sensitive chip comprises a signal processing circuit and a plurality of light-sensitive units one-to-one corresponding to the plurality of n-color filters, the plurality of light-sensitive units are respectively arranged to sense intensity of light transmitting through the plurality of n-color filters and to generate electric signals corresponding to the light transmitting through the plurality of n-color filters, the signal processing circuit is configured to process the electric signals for imaging; wherein a gain ratio of the signal processing circuit to the electric signals is A1: A2: ...: An, and an intensity transmittance ratio of the plurality of n-color filters of the color filter to the particular-wavelength infrared light is 1: (A1/A2): ...: (A1/An).

According to the image sensor in the embodiment of the present invention, when visible light and infrared light co-exist in an environment (e.g., in the sun), by adjusting optical characteristics of the color filter, the light-sensitive chip, when receiving visible light and particular-wavelength infrared light, can sense the two kinds of light at the same time and adjust an intensity transmittance of the particular-wavelength infrared light, causing the color of a shot image to be the same as that observed by the human eyes; in an environment where visible light is weak while infrared light is strong (e.g., when a fill light lamp is used to compensate light in the evening, the fill light lamp emits particular-wavelength infrared light), as the image sensor senses the particular-wavelength infrared light better, higher light sensitivity can still be obtained, an intensity transmittance of the particular-wavelength infrared light is adjusted, a clear black-and-white image can be shot, and it is unnecessary to use a mechanical device for assistance, which has a wide application range and is convenient and reliable.

To achieve the above objective, a monitoring system according to an embodiment in a second aspect of the present invention includes an electronic device, wherein the electronic device includes the image sensor according to the embodiment in the first aspect of the present invention; and a fill light lamp, wherein the fill light lamp emits the particular-wavelength infrared light.

According to the monitoring system in the embodiment of the present invention, when visible light and infrared light co-exist in an environment (e.g., in the sun), the color of a shot image is the same as that observed by the human eyes; in an environment where visible light is weak while infrared light is strong (e.g., when a fill light lamp is used to compensate light in the evening, the fill light lamp emits particular-wavelength infrared light), higher light sensitivity can still be obtained, a clear black-and-white image can be shot, and the image sensor does not need to use a mechanical device for assistance, which has a wide application range and is convenient and reliable.

To achieve the above objective, an image sensor according to an embodiment in a third aspect of the present invention includes: at least one light filter for filtering a particular-wavelength infrared light, wherein the light filter allows visible light and the particular-wavelength infrared light to transmit; a color filter located below the light filter, wherein the color filter comprises a plurality of n-color filters, wherein each of the plurality of n-color filters corresponds to one color, the plurality of n-color filters are arranged to divide visible light in incident light into n-color light, wherein n is a positive integer; and a light-sensitive chip located below the color filter, wherein the light-sensitive chip comprises a signal processing circuit and a plurality of light-sensitive units one-to-one corresponding to the plurality of n-color filters, the plurality of light-sensitive units are respectively arranged to sense intensity of light transmitting through the plurality of n-color filters and to generate electric signals corresponding to the light transmitting through the plurality of n-color filters, the signal processing circuit is configured to process the electric signals for imaging; wherein a gain ratio of the signal processing circuit to the electric signals is A1: A2: ...: An, and an intensity transmittance ratio of the plurality of n-color filters of the color filter to the particular-wavelength infrared light is 1: (A1/A2): ...: (A1/An).

According to the image sensor in the embodiment of the present invention, when visible light and infrared light co-exist in an environment (e.g., in the sun), by adjusting optical characteristics of the color filter and using a flight filter having particular optical characteristics, the light-sensitive chip, when receiving visible light and particular-wavelength infrared light, can sense the two kinds of light at the same time and adjust an intensity transmittance of the particular-wavelength infrared light, causing the color of a shot image to be the same as that observed by the human eyes; in an environment where visible light is weak while infrared light is strong (e.g., when a fill light lamp is used to compensate light in the evening, the fill light lamp emits particular-wavelength infrared light), as the image sensor senses the particular-wavelength infrared light better, higher light sensitivity can still be obtained, an intensity transmittance of the particular-wavelength infrared light is adjusted, a clear black-and-white image can be shot, and it is unnecessary to use a mechanical device for assistance, which has a wide application range and is convenient and reliable.

To achieve the above objective, a monitoring system according to an embodiment in a fourth aspect of the present invention includes an electronic device, wherein the electronic device includes the image sensor according to the embodiment in the third aspect of the present invention; and a fill light lamp, wherein the fill light lamp emits the particular-wavelength infrared light.

According to the monitoring system in the embodiment of the present invention, when visible light and infrared light co-exist in an environment (e.g., in the sun), the color of a shot image is the same as that observed by the human eyes; in an environment where visible light is weak while infrared light is strong (e.g., when a fill light lamp is used to compensate light in the evening, the fill light lamp emits particular-wavelength infrared light), a clear black-and-white image can be shot, and it is unnecessary to use a mechanical device for assistance, which has a wide application range and is convenient and reliable.

Additional aspects and advantages of the present invention will be partially given in the following description, and some will become evident from the following description or understood through practice of the present invention.

### BRIEF DESCRIPTION OF THE DRAWINGS

The aforementioned and/or additional aspects and advantages of the present invention will become evident and easy to understand from the following description about embodiments with reference to the accompanying drawings, and wherein:
FIG. 1(a) is a schematic diagram of increasing an IR filter on a sensitive channel of a CMOS image sensor in the prior art;
FIG. 1 (b) is a schematic diagram of spectral characteristics of the increased IR filter in the prior art;
FIG. 2 is a schematic structural diagram of an image sensor according to an embodiment of the present invention;
FIG. 3 is a schematic diagram of an image sensor according to an embodiment of the present invention;
FIG. 4 is a schematic diagram showing that red, green and blue light-sensitive units sense light according to an embodiment of the present invention;
FIG. 5(1) is a schematic diagram of optical characteristics of a red filter before adjustment according to an embodiment of the present invention;
FIG. 5(2) is a schematic diagram of optical characteristics of a green filter before adjustment according to an embodiment of the present invention;
FIG. 5(3) is a schematic diagram of optical characteristics of a blue filter before adjustment according to an embodiment of the present invention;
FIG. 6(1) is a schematic diagram of optical characteristics of a red filter after adjustment according to an embodiment of the present invention;
FIG. 6(2) is a schematic diagram of optical characteristics of a green filter after adjustment according to an embodiment of the present invention;
FIG. 6(3) is a schematic diagram of optical characteristics of a blue filter after adjustment according to an embodiment of the present invention;
FIG. 7(1) is a schematic structural diagram of an image sensor according to another embodiment of the present invention;
FIG. 7(2) is a schematic structural diagram of an image sensor according to a yet another embodiment of the present invention;
FIG. 7(3) is a schematic structural diagram of an image sensor according to a further embodiment of the present invention;
FIG. 8 is a schematic structural diagram of a monitoring system according to one embodiment of the present invention;
FIG. 9 is a schematic structural diagram of an image sensor according to another embodiment of the present invention;
FIG. 10 is a schematic diagram of optical characteristics of a light filter according to one embodiment of the present invention;
FIG. 11(1) is a schematic diagram of optical characteristics of a red filter according to one embodiment of the present invention;
FIG. 11(2) is a schematic diagram of optical characteristics of a green filter according to one embodiment of the present invention;
FIG. 11(3) is a schematic diagram of optical characteristics of a blue filter according to one embodiment of the present invention;
FIG. 12 is a schematic structural diagram of an image sensor according to one embodiment of the present invention; and
FIG. 13 is a schematic structural diagram of a monitoring system according to another embodiment of the present invention.

### DETAILED DESCRIPTION

The embodiments of the present invention are described below in detail, and examples of the embodiments are illustrated in the drawings, wherein identical or similar reference signs represent identical or similar elements or elements having identical or similar functions throughout the description. The following embodiments described with reference to the drawings are exemplary and only used to explain the present invention, but cannot be understood as limitations to the present invention.

The disclosure hereinafter provides lots of different embodiments or examples to implement different structures of the present invention. In order to simplify the disclosure of the present invention, components and settings of specific examples are described hereinafter. Certainly, they are merely exemplary and are not intended to limit the present invention. In addition, the present invention may repeat reference numbers and/or letters in different examples. Such repetition is for simplification and clarity, which does not indicate relationships between various embodiments and/or settings discussed. In addition, the present invention provides examples of various specific processes and materials, but those of ordinary skill in the art can realize applicability of other processes and/or use of other materials. Besides, the structure described below in which the first feature is "above" the second feature may include an embodiment in which the first and second features form a direct contact, and may also include an embodiment in which another feature is formed between the first and second features, and thus the first and second features may not in direct contact.

In the description of the present invention, it should be noted that, unless otherwise explicitly stipulated and defined, the terms "install", "connected with" and "connect" should be understood in a broad sense, for example, it may be a mechanical connection or an electrical connection, communication inside two elements, a direct connection or a connection through an intermediate medium. For those of ordinary skill in the art, the specific meanings of the terms can be understood according to specific situations.

Image sensors and monitoring systems according to embodiments of the present invention are described below with reference to the accompanying drawings.

FIG. 2 is a schematic structural diagram of an image sensor according to one embodiment of the present invention. The image sensor according to the embodiment of the present invention is a CMOS image sensor. As shown in FIG. 2, the image sensor 10 includes: a color filter 100, and a light-sensitive chip 200.

For infrared wavebands, the color filter 100 allows particular-wavelength infrared light to pass, an intensity transmittance of the color filter 100 to the particular-wavelength infrared light is adjustable, and the color filter 100 includes multiple n-color filters, wherein each filter corresponds to one color, the multiple n-color filters are used for dividing visible light in incident light into n-color light, wherein n is a positive integer.

Specifically, for visible light, the color filter 100 allows part of the visible light to transmit, while for infrared light, the color filter 100 only allows particular-wavelength infrared light to pass, and the intensity transmittance of the color filter 100 to the particular-wavelength infrared light can be adjusted in advance. For visible light, the color filter 100 allows part of the visible light to transmit, which means that the color filter 100 includes multiple-color filters, for example, when the color filter 100 includes red, green and blue filters, the red filter only allows red light in the visible light to transmit, the green filter only allows green light in the visible light to transmit, and the blue filter only allows blue light in the visible light to transmit.

For the light-sensitive chip 200 located below the color filter 100, the light-sensitive chip 200 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is A1: A2: ...: An, wherein an intensity transmittance of the multiple n-color filters of the color filter 100 to the particular-wavelength infrared light is 1: (A1/A2): ...: (A1/An).

For ease of description, description is given below by taking that n=3 and the filters are red, green and blue filters as an example.

Specifically, the color filter 100 (which can be abbreviated as CF) has light transmission selectivity (that is, only particular light is allowed to pass) and intensity attenuation (that is, intensity of passing light may decrease). The color filter 100 includes multiple red, green and blue filters used for dividing visible light in incident light into three primary colors, red, green and blue, and for infrared light wavebands, the red, green and blue filters only allow particular-wavelength infrared light (e.g., infrared light whose wavelength is 850 nm+-50 nm) to pass.

It should be noted that that the color filter 100 includes red, green and blue filters is merely an example made for facilitating description, the color filter 100 may further include filters in other colors, for example, the color filter 100 may include cyan, carmine (or magenta) and yellow filters, and the color filter 100 may include red, green, blue and white filters.

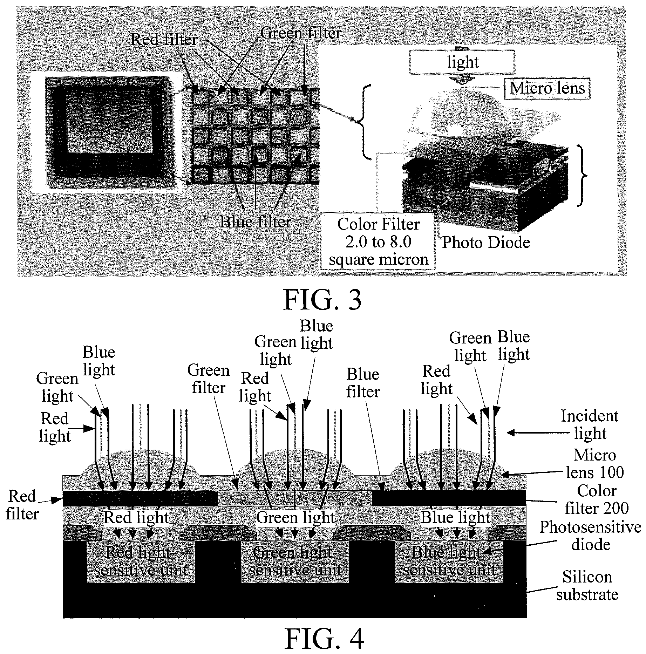

The light-sensitive chip 200 is located below the color filter 100, the light-sensitive chip 200 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is A1: A2: ...: An, wherein an intensity transmittance of the multiple n-color filters of the color filter to the particular-wavelength infrared light is 1: (A1/A2): ...: (A1/An). The light-sensitive units may be photosensitive diodes. FIG. 3 is a schematic diagram of an image sensor. In FIG. 3, light indicates the incident light, Micro Lens is the micro lens, Color Filter is the color filter 100, and Photo Diode is the photosensitive diode, used for sensing light and converting light signals to electric signals. As shown in FIG. 3, red, green and blue filters are arranged in a certain order to form an array, for example, colors of filters from left to right in odd-numbered lines (e.g., Line 1, Line 3, Line 5) are sequentially red, green, red, green, red, green ..., and colors of filters from left to right in even-numbered lines (e.g., Line 2, Line 4) are sequentially green, blue, green, blue, green, blue ...

Specifically, the light-sensitive chip 200 conducts imaging according to light transmitting through the red, green and blue filters of the color filter 100. The signal processing circuit processes corresponding electric signals in an order of arrangement of the filters, to restore actual colors and form pictures. More specifically, the light transmitting through the red, green and blue filters of the color filter 100 passes through the photosensitive diodes, the light signals are converted to electric signals, and the electric signals can generate an image after being processed by the signal processing circuit. FIG. 4 is a schematic diagram showing that red, green and blue light-sensitive units sense light. The red, green and blue light-sensitive units one-to-one correspond to the red, green and blue filters.

In addition, in the embodiment of the present invention, the gain ratio of the signal processing circuit to the electric signals A1: A2: ...: An is obtained according to the intensity transmittance of the multiple n-color filters of the color filter to the particular-wavelength infrared light. As required by a picture to be formed, at first, the intensity transmittance of the multiple n-color filters of the color filter to the particular-wavelength infrared light is determined as 1: (A1/A2): ...: (A1/An), next, in a testing process, the gain ratio of the signal processing circuit to the electric signals is determined according to the intensity transmittance of the multiple n-color filters of the color filter to the particular-wavelength infrared light, that is, the gain ratio of the signal processing circuit to the electric signals A1: A2: ...: An is obtained through testing.

Specifically, the red, green and blue filters are still taken as an example; in the sun, infrared light is filtered, and only visible light remains; at this point, the red, green and blue light-sensitive units sense intensity of the visible light, which is converted to electric signals and then will be processed by the signal processing circuit, and then an image in a pure color is output; at this point, the gain ratio of the signal processing circuit to the electric signals correspondingly generated by red, green and blue visible light is A1: A2: A3. Certainly, according to requirements, it is known to those skilled in the art that the red, green and blue visible light can be processed, to cause a component ratio of the red, green and blue visible light in the finally obtained image to be 1:1:1, thus obtaining an image whose color is the same as that of an actual object.

In one embodiment of the present invention, in a specific application environment of the image sensor, a fill light lamp can be selected to compensate light for the image sensor, and the fill light lamp emits particular-wavelength infrared light.

In the embodiment of the present invention, the particular wavelength matches the wavelength of the infrared light emitted by the selected fill light lamp. Specifically, in a range of infrared wavebands, the color filter 100 only allows particular-wavelength infrared light to transmit, and other-wavelength infrared light cannot transmit through the color filter 100.

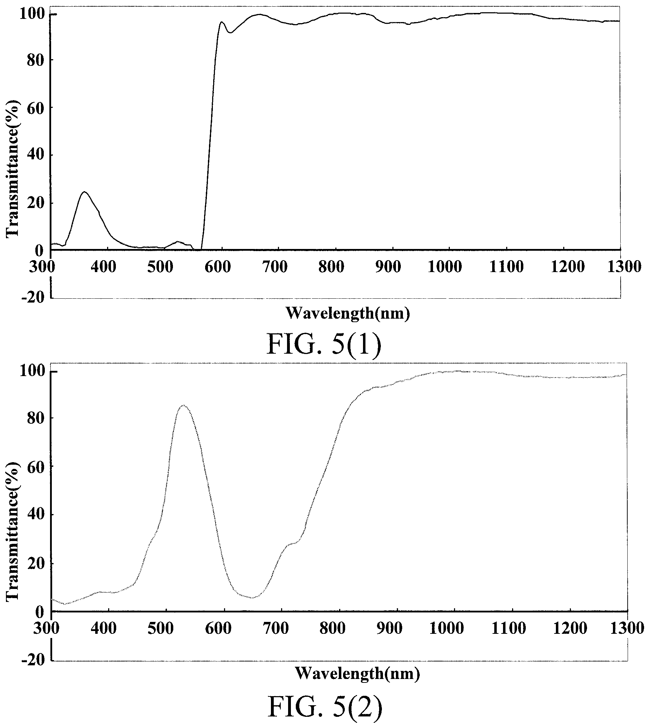

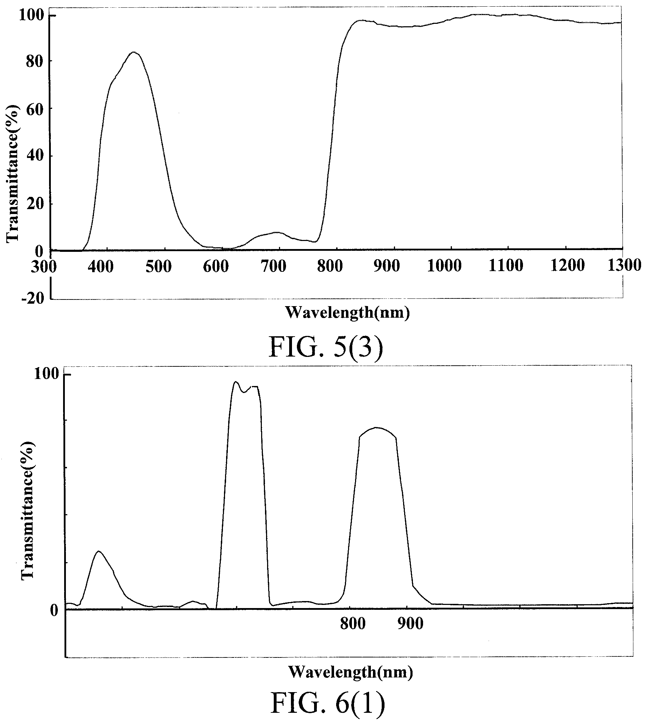

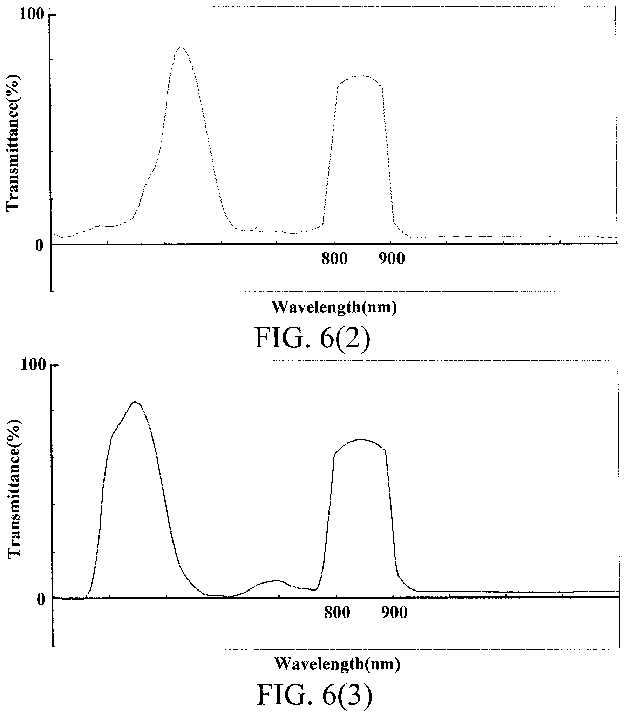

In the embodiment of the present invention, in the evening, the wavelength of the infrared light emitted by the fill light lamp is λ (e.g., a fill light lamp of 850 nm+-50 nm is used). By adjusting optical characteristics of the CF in advance, only infrared light whose wavelength is λ (850 nm+-50 nm) can pass, while infrared light in other wavebands is cut off. The optical characteristics of the CF are as follows: optical characteristics of visible light wavebands remain unchanged, and in infrared light wavebands, infrared light with an infrared wavelength of λ (850 nm+-50 nm) used by the fill light lamp passes. At the same time, for the infrared light with a wavelength of λ (850 nm+-50 nm), the intensity transmittance of the multiple red, green and blue filters of the color filter 100 to the particular-wavelength (λ) infrared light is 1: (A1/A2): (A1/A3). FIG. 5(1) is a schematic diagram of optical characteristics of a red filter before adjustment, FIG. 5(2) is a schematic diagram of optical characteristics of a green filter before adjustment, FIG. 5(3) is a schematic diagram of optical characteristics of a blue filter before adjustment, FIG. 6(1) is a schematic diagram of optical characteristics of a red filter after adjustment, FIG. 6(2) is a schematic diagram of optical characteristics of a green filter after adjustment, and FIG. 6(3) is a schematic diagram of optical characteristics of a blue filter after adjustment.

In the embodiment of the present invention, when the light-sensitive chip 200 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 100 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 200, and then the component ratio of red, green and blue colors under infrared in the obtained image is 1:1:1; the ratio is gray scale of brightness, and thus incidence of the infrared light may not affect the restored color of the visible light. Moreover, due to addition of intensity of the infrared light, the image is brighter and has better definition.

In the embodiment of the present invention, when the light-sensitive chip 200 senses single infrared light (the wavelength is λ) emitted by the fill light lamp, because the CF allows the infrared light whose wavelength is λ to transmit, the human eyes cannot see an object clearly when only the fill light lamp is present in the evening, but the light-sensitive chip 200 still can sense the infrared light whose wavelength is λ, after the infrared light passes through the red, green and blue filters whose intensity transmittance is 1: (A1/A2): (A1/A3), the intensity sensed by the light-sensitive units corresponding to the red, green and blue filters is 1: (A1/A2): (A1/A3), during processing of the signal processing circuit, the gain ratio of the signal processing circuit to the electric signals correspondingly generated by the light transmitting through the red, green and blue filters is A1: A2: A3, so that the component ratio of red, green and blue colors in the obtained image is 1:1:1; and at this point, the image is a normal black-and-white image.

According to the image sensor in the embodiment of the present invention, in an environment where the visible light and the infrared light co-exist, the imaging color may not produce color cast, and brightness and definition of the image are good, which can be applied to more fields and can be especially applied to security and protection monitoring.

In addition, when the image sensor in the embodiment of the present invention is machined into a product, as different parameters may have lots of product models, generally, the gain ratio of the signal processing circuit corresponding to the image sensor of the same model to the electric signals corresponding to the light transmitting through the multiple n-color filters A1:A2:...An is the same. In addition, it is possible to adjust the gain ratio of the signal processing circuit to the electric signals according to different scenarios, to achieve restoration of the actual color.

According to the image sensor in the embodiment of the present invention, when the visible light and the infrared light co-exist in an environment (e.g., in the sun), by adjusting optical characteristics of the color filter, the light-sensitive chip, when receiving visible light and particular-wavelength infrared light, can sense the two kinds of light at the same time and adjust an intensity transmittance of the particular-wavelength infrared light, causing the color of a shot image to be the same as that observed by the human eyes; in an environment where visible light is weak while infrared light is strong (e.g., when a fill light lamp is used to compensate light in the evening, the fill light lamp emits particular-wavelength infrared light), as the image sensor senses the particular-wavelength infrared light better, higher light sensitivity can still be obtained, an intensity transmittance of the particular-wavelength infrared light is adjusted, a clear black-and-white image can be shot, and it is unnecessary to use a mechanical device for assistance, which has a wide application range and is convenient and reliable.

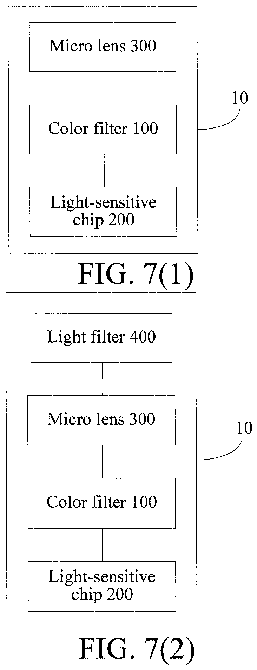

In another embodiment of the present invention, as shown in FIG. 7(1), the image sensor 10 further includes: a micro lens 300, wherein the micro lens 300 is located above the color filter 100, and the micro lens 300 is used for receiving and converging the incident light. Specifically, light passes through the micro lens 300, and the micro lens 300 converges and strengthens the light.

In one embodiment of the present invention, as shown in FIG. 7(2), the image sensor 10 may further include a light filter 400. The light filter 400 is located above the micro lens 300, used for filtering infrared light except the particular-wavelength infrared light, so that a filtering effect is better, and thus the effect of the shot image is also better.

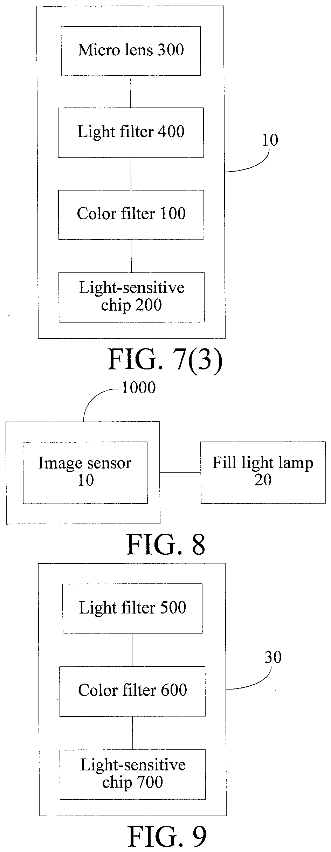

In another embodiment of the present invention, as shown in FIG. 7(3), the light filter 400 may also be directly placed above the color filter 100.

In order to achieve the above embodiment, the present invention further proposes a monitoring system.

FIG. 8 is a schematic structural diagram of a monitoring system according to one embodiment of the present invention.

As shown in FIG. 8, the monitoring system includes an electronic device 1000 and a fill light lamp 20.

The electronic device 1000 has an image sensor 10, and the fill light lamp 20 emits particular-wavelength infrared light.

According to the monitoring system in the embodiment of the present invention, when visible light and infrared light co-exist in an environment (e.g., in the sun), the color of a shot image is the same as that observed by the human eyes; in an environment where visible light is weak while infrared light is strong (e.g., when a fill light lamp is used to compensate light in the evening, the fill light lamp emits particular-wavelength infrared light), higher light sensitivity can still be obtained, a clear black-and-white image can be shot, and the image sensor does not need to use a mechanical device for assistance, which has a wide application range and is convenient and reliable.

FIG. 9 is a schematic structural diagram of an image sensor according to another embodiment of the present invention.

As shown in FIG. 9, the image sensor 30 includes: at least one light filter 500, a color filter 600 and a light-sensitive chip 700.

The light filter 500 is used for filtering infrared light except the particular-wavelength infrared light. The light filter 500 allows visible light and the particular-wavelength infrared light to transmit.

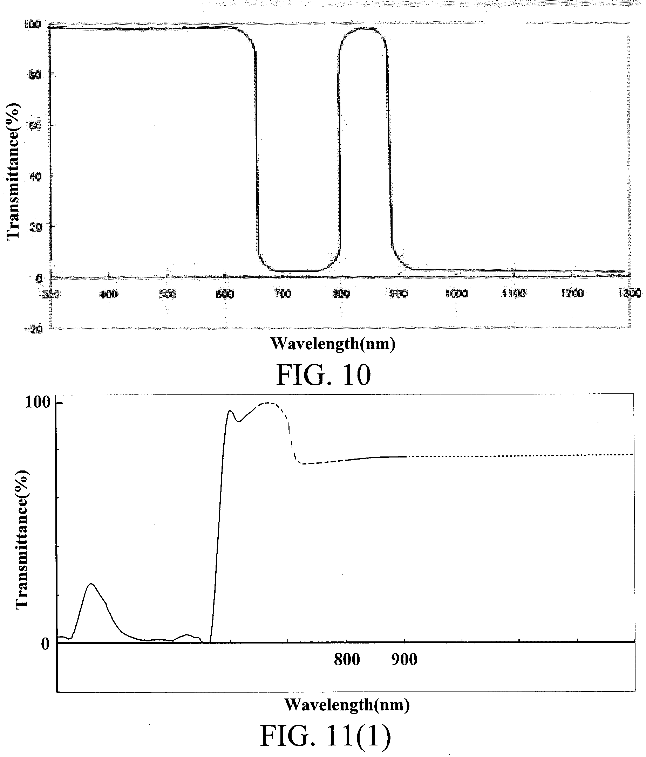

Specifically, the light filter 500 is an IR filter, and the light filter 500 is used for filtering infrared light except the particular-wavelength infrared light. That is, the light filter 500 allows visible light and the particular-wavelength infrared light to pass. For example, by taking that the wavelength of the particular-wavelength infrared light is 850 nm+-50 nm as an example, FIG. 10 is a schematic diagram of optical characteristics of the light filter 500.

The color filter 600 is located below the light filter 500, wherein the color filter 600 includes multiple n-color filters, wherein each filter corresponds to one color, the multiple n-color filters are used for dividing visible light in incident light into n-color light, wherein n is a positive integer. The light-sensitive chip 700 is located below the color filter 600, wherein the light-sensitive chip 700 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is A1: A2: ...: An, wherein an intensity transmittance of the multiple n-color filters of the color filter 600 to the particular-wavelength infrared light is 1: (A1/A2): ...: (A1/An).

For ease of description, description is given below by taking that n=3 and the filters are red, green and blue filters as an example.

Specifically, the color filter 600 (which can be abbreviated as CF) has intensity attenuation (that is, intensity of passing light may decrease). The color filter 600 includes multiple red, green and blue filters used for dividing visible light in incident light into three primary colors, red, green and blue.

It should be noted that that the color filter 600 includes red, green and blue filters is merely an example made for facilitating description, the color filter 600 may further include filters in other colors, for example, the color filter 600 may include cyan, carmine (or magenta) and yellow filters, and for another example, the color filter 600 may include red, green, blue and white filters.

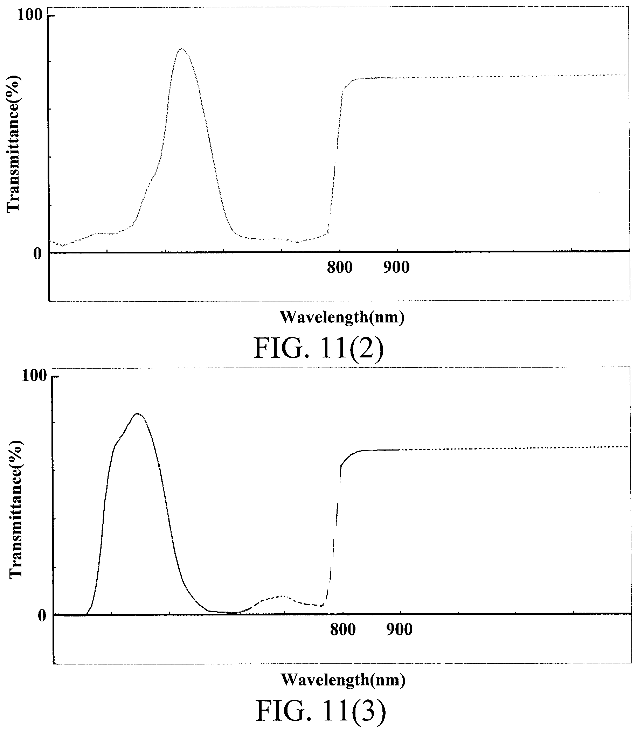

Specifically, the light-sensitive chip 700 conducts imaging according to light transmitting through the red, green and blue filters of the color filter 600. The red, green and blue filters are arranged in a certain order to form an array. The signal processing circuit processes corresponding electric signals in an order of arrangement of the filters, to restore actual colors and form pictures. More specifically, the light transmitting through the red, green and blue filters of the color filter 600 reaches the underlying photosensitive diode, the light signals are converted to electric signals, and the electric signals can generate an image after being processed by the signal processing circuit. More specifically, the optical characteristics of the color filter 600 are adjusted, to cause the intensity transmittance of the multiple red, green and blue filters of the color filter 600 to the particular-wavelength (e.g., 850 nm+-50 nm) infrared light to be 1: (A1/A2): (A1/A3). As the light filter 500 can filter infrared light except the particular-wavelength infrared light, the intensity transmittance of infrared light in other wavelength ranges does not need to be specially adjusted. FIG. 11(1), FIG. 11(2) and FIG. 11(3) are respectively schematic diagrams of optical characteristics of red, green and blue filters, wherein the dotted line indicates that the value may be arbitrary. Certainly, for ease of convenience, it is possible to adjust the intensity transmittance of all the infrared light as 1: (A1/A2): (A1/A3); in fact, the infrared light in other wavelength ranges except the particular-wavelength infrared light can be adjusted arbitrarily.

In the embodiment of the present invention, the gain ratio of the signal processing circuit to the electric signals corresponding to the light transmitting through the multiple n-color filters A1: A2: ...: An is obtained according to the intensity transmittance of the multiple n-color filters of the color filter to the particular-wavelength infrared light. As required by a picture to be formed, at first, the intensity transmittance of the multiple n-color filters of the color filter to the particular-wavelength infrared light is determined as 1: (A1/A2): ...: (A1/An), next, in a testing process, the gain ratio of the signal processing circuit to the electric signals is determined according to the intensity transmittance of the multiple n-color filters of the color filter to the particular-wavelength infrared light, that is, the gain ratio of the signal processing circuit to the electric signals A1: A2: ...: An is obtained through testing.

Specifically, the red, green and blue filters are still taken as an example; in the sun, infrared light is filtered, and only visible light remains; at this point, the red, green and blue light-sensitive units sense intensity of the visible light, which is converted to electric signals and then will be processed by the signal processing circuit, and then an image in a pure color is output; at this point, the gain ratio of the signal processing circuit to the electric signals corresponding to red, green and blue visible light is A1: A2: A3. Certainly, according to requirements, it is known to those skilled in the art that the red, green and blue visible light can be processed, to cause a component ratio of the red, green and blue visible light in the finally obtained image to be 1:1:1, thus obtaining an image whose color is the same as that of an actual object.

In one embodiment of the present invention, in a specific application environment of the image sensor, a fill light lamp can be selected to compensate light for the image sensor, and the fill light lamp emits particular-wavelength infrared light.

In the embodiment of the present invention, the particular wavelength matches the wavelength of the infrared light emitted by the selected fill light lamp. That is, the light filter 500 and the selected fill light lamp cooperate for use. Specifically, for example, the wavelength of the infrared light emitted by the fill light lamp is λ, and the light filter 500 allows the infrared light whose wavelength is λ to pass but filters other-wavelength infrared light.

In the embodiment of the present invention, when the light-sensitive chip 700 senses a complicated spectral signal (visible light + infrared light), for the visible light, as the gain ratio of the signal processing circuit to the electric signals corresponding to the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, the actual visible light color can be restored. For the infrared light, as the intensity transmittance of the multiple red, green and blue filters of the color filter 600 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 700, and then the component ratio of red, green and blue colors under infrared in the obtained image is 1:1:1; the ratio is gray scale of brightness, and thus incidence of the infrared light may not affect the restored color of the visible light. Moreover, due to addition of intensity of the infrared light, the image is brighter and has better definition.

In the embodiment of the present invention, when the light-sensitive chip 700 senses single infrared light (the wavelength is λ) emitted by the fill light lamp, because the color filter 500 allows the infrared light whose wavelength is λ to transmit, the human eyes cannot see an object clearly when only the fill light lamp is present in the evening. However, the light-sensitive chip 700 still can sense the infrared light whose wavelength is λ, after the infrared light passes through the red, green and blue filters whose intensity transmittance is 1: (A1/A2): (A1/A3), the intensity sensed by the light-sensitive units corresponding to the red, green and blue filters is 1: (A1/A2): (A1/A3), during processing of the signal processing circuit, the gain ratio of the signal processing circuit to the electric signals correspondingly generated by the light transmitting through the red, green and blue filters is A1: A2: A3, so that the component ratio of red, green and blue colors in the obtained image is 1:1:1; and at this point, the image is a normal black-and-white image.

According to the image sensor in the embodiment of the present invention, in an environment where the visible light and the infrared light co-exist, the imaging color may not produce color cast, and brightness and definition of the image are good, which can be applied to more fields and can be especially applied to security and protection monitoring.

In addition, when the image sensor in the embodiment of the present invention is machined into a product, as different parameters may have lots of product models, generally, the gain ratio of the signal processing circuit corresponding to the image sensor of the same model to the electric signals corresponding to the light transmitting through the multiple n-color filters A1:A2:...An is the same. In addition, it is possible to adjust the gain ratio of the signal processing circuit to the electric signals according to different scenarios, to achieve restoration of the actual color.

According to the image sensor in the embodiment of the present invention, when the visible light and the infrared light co-exist in an environment (e.g., in the sun), by adjusting optical characteristics of the color filter and using a light filter having particular optical characteristics, the light-sensitive chip, when receiving visible light and particular-wavelength infrared light, can sense the two kinds of light at the same time, and adjusts an intensity transmittance of the particular-wavelength infrared light, causing the color of a shot image to be the same as that observed by the human eyes; in an environment where visible light is weak while infrared light is strong (e.g., when a fill light lamp is used to compensate light in the evening, the fill light lamp emits particular-wavelength infrared light), as the image sensor senses the particular-wavelength infrared light better, higher light sensitivity can still be obtained, an intensity transmittance of the particular-wavelength infrared light is adjusted, a clear black-and-white image can be shot, and it is unnecessary to use a mechanical device for assistance, which has a wide application range and is convenient and reliable.

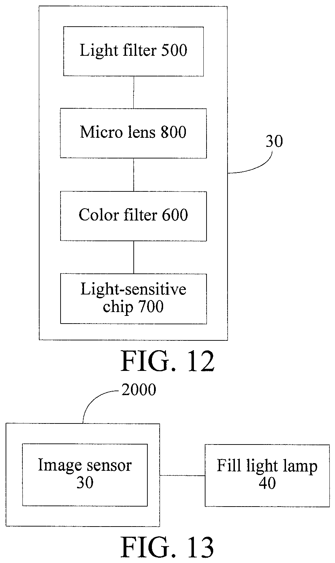

In one embodiment of the present invention, as shown in FIG. 12, the image sensor 30 further includes: a micro lens 800, wherein the micro lens 800 is located between the at least one light filter 500 and the color filter 600, and the micro lens 800 is used for receiving and converging the incident light. Specifically, light passes through the micro lens 800, and the micro lens 800 converges and strengthens the light.

In order to achieve the above embodiment, the present invention further proposes a monitoring system.

FIG. 13 is a schematic structural diagram of a monitoring system according to one embodiment of the present invention.

As shown in FIG. 13, the monitoring system includes an electronic device 2000 and a fill light lamp 40.

The electronic device 2000 has an image sensor 30, and the fill light lamp 40 emits particular-wavelength infrared light.

According to the monitoring system in the embodiment of the present invention, when visible light and infrared light co-exist in an environment (e.g., in the sun), the color of a shot image is the same as that observed by the human eyes; in an environment where visible light is weak while infrared light is strong (e.g., when a fill light lamp is used to compensate light in the evening, the fill light lamp emits particular-wavelength infrared light), a clear black-and-white image can be shot, and it is unnecessary to use a mechanical device for assistance, which has a wide application range and is convenient and reliable.

In the description of the present invention, it should be understood that direction or position relationships indicated by the terms "center", "longitudinal", "transverse", "length", "width", "thickness", "up", "down", "front", "back", "left", "right", "vertical", "horizontal", "top", "bottom", "inner", "outer", "clockwise", "counterclockwise", "axial", "radial", "circumferential" and the like are direction or position relationships shown based on the accompanying drawings, which are merely intended to make it easy to describe the present invention and simplify the description, instead of indicating or implying that the apparatus or element indicated has to have a particular direction and to be constructed or operated with the particular direction, and thus cannot be constructed as limitations to the present invention.

In addition, the terms "first" and "second" are only used for description but cannot be understood as indicating or implying relative importance or implicitly indicating the number of the indicated technical feature. Thus, the features defined with "first" and "second" can explicitly or implicitly include at least one of the features. In the description of the present invention, the meaning of "multiple" is at least two, for example, two, three or the like, unless otherwise definitely and specifically defined.

In the present invention, unless otherwise explicitly stipulated and defined, the terms "install", "connected with", "connect" and "fix" should be understood in a broad sense, for example, it may be a fixed connection, a detachable connection or an integral connection; may be a mechanical connection or an electrical connection; may be a direct connection or a connection through an intermediate medium, and may be communication inside two elements or an interaction relationship of two elements, unless otherwise explicitly defined. For those of ordinary skill in the art, the specific meanings of the terms in the present invention can be understood according to specific situations.

In the present invention, unless otherwise explicitly stipulated and defined, the first feature being "up" or "down" the second feature may be that the first and second features are in direct contact, or the first and second features are in direct contact through an intermediate medium. Moreover, the first feature being "above", "over" and "on" the second feature may be that the first feature is directly over or obliquely over the second feature, or merely indicates that the level height of the first feature is higher than that of the second feature. The first feature being "below", "beneath" and "under" the second feature may be that the first feature is directly beneath or obliquely beneath the second feature, or merely indicates that the level height of the first feature is less than that of the second feature.

In the description of the specification, the description of reference terms "one embodiment", "some embodiments", "example", "specific example" or "some examples" and the like means that specific features, structures, materials or features described in combination with the embodiment(s) or example(s) are included in at least one embodiment or example of the present invention. In the specification, schematic expression of the above terms may not necessarily refer to the same embodiment or example. Moreover, the described specific features, structures, materials or features may be combined in an appropriate manner in any one or more embodiments or examples. In addition, in a situation of not being mutually contradictory, those skilled in the art can unite and combine different embodiments or examples and features of the different embodiments or examples described in the specification.

Although the embodiments of the present invention have been illustrated and described above, it would be appreciated that the above embodiments are exemplary and cannot be construed as limiting the present invention. Those of ordinary skill in the art can make changes, modifications, replacements and variations to the above embodiments within the scope of the present invention.

## Claims

1. An image sensor, comprising:
a color filter arranged to allow a particular-wavelength infrared light to pass for light in infrared wavebands, and comprising a plurality of n-color filters, wherein each of the plurality of n-color filters corresponds to one color, the plurality of n-color filters are configured to divide visible light of incident light into n-color light, wherein n is a positive integer; and
a light-sensitive chip located below the color filter, wherein the light-sensitive chip comprises a signal processing circuit and a plurality of light-sensitive units one-to-one corresponding to the plurality of n-color filters, the plurality of light-sensitive units are respectively arranged to sense intensity of light transmitting through the plurality of n-color filters and to generate electric signals corresponding to the light transmitting through the plurality of n-color filters, the signal processing circuit is configured to process the electric signals for imaging;
wherein a gain ratio of the signal processing circuit to the electric signals is A1: A2: ...: An, and an intensity transmittance ratio of the plurality of n-color filters of the color filter to the particular-wavelength infrared light is 1: (A1/A2): ...: (A1/An).

2. The image sensor according to claim 1, further comprising:
a micro lens located above the color filter, wherein the micro lens is arranged to receive and converge the incident light.

3. The image sensor according to claim 1 or 2, wherein the gain ratio of the signal processing circuit to the electric signals A1: A2: ...: An is obtained according to the intensity transmittance of the plurality of n-color filters of the color filter to the particular-wavelength infrared light.

4. The image sensor according to claim 2, further comprising:
a light filter located above the micro lens, and arranged to filter the particular-wavelength infrared light, such that the particular wavelength infrared light passes through the light filter.

5. The image sensor according to any one of claims 1 to 3, further comprising:
a light filter located above the color filter, and arranged to filter the particular-wavelength infrared light, such that the particular wavelength infrared light passes through the light filter.

6. A monitoring system, comprising:
an electronic device, wherein the electronic device comprises the image sensor according to any one of claims 1 to 5; and
a fill light lamp, wherein the fill light lamp emits the particular-wavelength infrared light.

7. An image sensor, comprising:
at least one light filter for filtering a particular-wavelength infrared light, wherein the light filter allows visible light and the particular-wavelength infrared light to transmit;
a color filter located below the light filter, wherein the color filter comprises a plurality of n-color filters, wherein each of the plurality of n-color filters corresponds to one color, the plurality of n-color filters are arranged to divide visible light in incident light into n-color light, wherein n is a positive integer; and
a light-sensitive chip located below the color filter, wherein the light-sensitive chip comprises a signal processing circuit and a plurality of light-sensitive units one-to-one corresponding to the plurality of n-color filters, the plurality of light-sensitive units are respectively arranged to sense intensity of light transmitting through the plurality of n-color filters and to generate electric signals corresponding to the light transmitting through the plurality of n-color filters, the signal processing circuit is configured to process the electric signals for imaging;
wherein a gain ratio of the signal processing circuit to the electric signals is A1: A2: ...: An, and an intensity transmittance ratio of the plurality of n-color filters of the color filter to the particular-wavelength infrared light is 1: (A1/A2): ...: (A1/An).

8. The image sensor according to claim 7, further comprising:
a micro lens located between the at least one light filter and the color filter, and arranged to receive and converge the incident light.

9. The image sensor according to claim 7 or 8, wherein the gain ratio of the signal processing circuit to the electric signals A1: A2: ...: An is obtained according to the intensity transmittance of the plurality of n-color filters of the color filter to the particular-wavelength infrared light.

10. A monitoring system, comprising:
an electronic device, wherein the electronic device comprises the image sensor according to any one of claims 7 to 9; and
a fill light lamp, wherein the fill light lamp emits the particular-wavelength infrared light.
